# EUROPEAN PATENT SPECIFICATION

(11) **EP 0 467 079 B1**
(45) Date of publication and mention of the grant of the patent: **02.09.1998**
(21) Application number: 91109948.9
(22) Date of filing: 18.06.1991
(51) Int. Cl.: G06F 3/06, G06F 11/00

(54) **Disc array storage system**
Plattenanordnungsspeichersystem
Système de stockage sous forme de réseau de disques

(30) Priority: 19.06.1990 JP 160315/90
(43) Date of publication of application: 22.01.1992
(73) Proprietor: FUJITSU LIMITED, Kawasaki-shi, Kanagawa 211 (JP)
(72) Inventor: Ohizumi, Yumiko, c/o FUJITSU LIMITED, Kawasaki-shi, Kanagawa 211 (JP)
(74) Representative: Sunderland, James Harry

(56) References cited:
- EP-A- 0 369 707
- WO-A-90/00280

## Description

The present invention relates to array disc memory equipment. As computer processing speeds have increased, data transfer speeds and data capacities of computer auxiliary memory equipment have also increased. Array disc memory equipment, hereinafter referred to as "array disc equipment", is one kind of auxiliary memory equipment which has been developed for writing and reading a large amount of data at high speed.

Array disc equipment consists of a plurality of disc drive modules and a control unit for controlling the modules. When the array disc equipment is commanded by higher ranking equipment of a computer, for example a channel, to perform data writing or data reading, the control unit divides data sent from the channel into a plurality of divided data portions each of a proper length. Then the control unit controls the disc drive modules so that the divided data portions are simultaneously read into the disc drive modules in parallel. When the array disc equipment is commanded by the channel to read data, the control unit controls the disc drive modules so that the divided data portions stored in the disc drive modules are simultaneously read out therefrom in parallel and are combined into the data to be sent to the channel.

As will be understood from the above, the division of data into divided data portions and the writing of the divided data portions into the disc drive modules in parallel, and the reading of the divided data portions from the disc drive modules in parallel and combining them into data, are significant features of array disc equipment. With the development of auxiliary memory equipment to provide array disc equipment having such features, the speed of data writing and reading becomes very high.

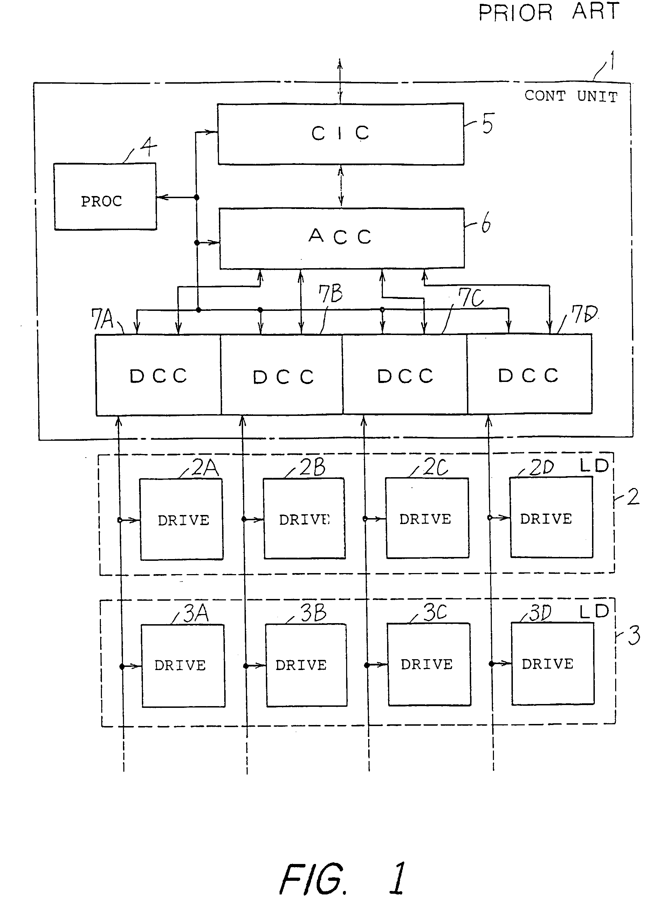

Fig. 1 is a schematic block diagram of an array disc equipment of the related art. In Fig. 1, a box having reference sign 1 indicates a control unit (CONT UNIT), and boxes having reference signs 2A to 2D and 3A to 3D indicate disc drive modules (DRIVEs). In consideration of logical addresses used for dividing received data into divided data portions, DRIVEs are grouped into a plurality of logical devices (LDs). Actually, there are many DRIVEs in the array disc equipment; in this example, however, eight DRIVEs 2A to 2D and 3A to 3D are shown and four DRIVEs, 2A to 2D and 3A to 3D respectively, are grouped in each of LDs 2 and 3 respectively in Fig. 1. Not depicted in Fig. 1, each DRIVE includes a memory disc, a drive control circuit for controlling a drive of the memory disc and a head, and other components such as a head mechanically touching the surface of the memory disc. As shown in Fig. 1, CONT UNIT 1 consists of a channel interface circuit (CIC) 5 placed at a signal entrance and exit of the array disc equipment and connected to a channel, an array control circuit (ACC) 6 connected to CIC 5, four device control circuits (DCCs) 7A to 7D placed between ACC 6 and LDs 2, 3, ---, and a processor (PROC) 4 connected to CIC 5, ACC 6 and DCCs 7A to 7D. The number of DCCs depends on the number of DRIVEs in each LD.

When the array disc equipment receives a command from the channel to write data into the array disc equipment, the command is fed to PROC 4 through CIC 5 and PROC 4 allows the channel to send the data to ACC 6 through CIC 5 and instructs ACC 6 to write the data into DRIVEs 2A to 2D and 3A to 3D. When ACC 6 receives such instruction from PROC 4 and the data through CIC 5 and if the data consists of 8 bytes, ACC 6 divides the data into 4 divided data portions, dividing every 2 bytes from the beginning of the 8 byte data. If the logical address of the data is designated to LD 2 in the command from the channel, the command is instructed to ACC 6 from PROC 4, then ACC 6 controls DCCs 7A to 7D so that DCCs 7A to 7D access DRIVEs 2A to 2D in LD 2 for storing the divided data portions therein in parallel. As a result, DCC 7A controls DRIVE 2A so as to position the head on a designated cylinder on a designated track of the memory disc and write the first 2 byte divided data portion into a designated sector of the designated cylinder. Similarly to DCC 7A, the other DCCs 7B, 7C and 7D simultaneously write the second, third and fourth 2 byte divided data portions into designated sectors of the memory discs of DRIVEs 2B, 2C and 2D respectively in parallel.

When the array disc equipment receives a command from the channel to read data stored in LD 2, the command is fed to PROC 4 through CIC 5 and PROC 4 instructs ACC 6 so that ACC 6 controls DCCs 7A to 7D so as to read the divided data portions from DRIVEs 2A to 2D in LD 2 respectively. That is, DCCs 7A to 7D control DRIVEs 2A to 2D in LD 2 so as to position the heads on designated sectors of designated cylinders on designated tracks of DRIVEs respectively and read the 2 byte divided data portions from DRIVEs 2A to 2D in parallel. The 2 byte divided data portions read from DRIVEs 2A to 2D are combined to form 8 byte data in ACC 6 and the 8 byte data is sent to the channel through CIC 5. Writing and reading steps similar to those described above are performed in relation to DRIVEs 3A to 3D when the array disc equipment receives write and read commands relating to LD 3.

In previously proposed array disc equipment, generally, DRIVEs are connected to respective DCCs through connection cables, and the connection cables must be disconnected and connected when DRIVEs are required to be replaced or expanded. Therefore, when the connection cables are reconnected after some DRIVEs are replaced or reinstalled, a mistake may be made in cable connection. If a mistake is made, there occurs a problem in that the set positions of the DRIVEs are confused, so that incorrectly divided data portions are written into or read from DRIVEs, resulting in the production of confused data. Furthermore, if such trouble occurs in a computer, a great deal of time and effort may be wasted in determining the nature of the misconnection of the DRIVES.

For instance, if some of DRIVEs 2A to 2D are mistaken in their connections with DCCs 7A to 7D, due to the replacement of some DRIVEs, it becomes impossible to correctly read out data stored in the array disc equipment, which is fatal for computer operations and it requires a great deal of effort to determine where the wrong connections are.

EP-A-0 369 707 discloses array disc memory equipment according to the preamble of accompanying claim 1. This document also discloses a configuration file of the array disc memory equipment which provides logical to physical memory mapping, a logical disc name being specified by a host computer when sending a data transfer request to the array disc memory equipment. An algorithm is provided in a disc controller of the array disc memory equipment which determines whether a disc drive module has been removed and whether an inserted disc drive module is in the correct position. It is disclosed that a date and time stamp could be made on each disc drive module at its initial connection; and that alternatively serial numbers or codes could be used.

According to the present invention, there is provided array disc memory equipment, for use with a computer, for storing data sent from the computer by dividing the data into a plurality of divided data portions for storage in parallel, and for reading data and sending the read data to the computer by reading stored divided data portions and combining them into the read data, said array disc memory equipment comprising a plurality of disc drive modules, for storing divided data portions, each module comprising a memory disc on which identification information, identifying the disc drive module, is memorized; characterised by: read and memory means, for storing, in designated logical addresses of said read and memory means, first identification information relating to said disc drive modules previously installed in designated positions of the array disc memory equipment, and operable to read second identification information on said disc drive modules installed in the designated positions; comparison means operable to compare the second identification information with the first identification information indicated by the designated logical addresses every time a power supply of said disc drive modules is turned on; confirmation means for confirming, after performance of the comparison by said comparison means, whether the disc drive modules installed in the designated positions, producing second identification information, belong to the same group and have second identification information identical to the first identification information; data division and integration means for (i) dividing data, sent from a computer with which the equipment is employed to the array disc memory equipment, into divided data portions to be stored in the disc drive modules, when the array disc memory equipment operates under control of a data write command sent from the computer, and (ii) integrating divided data portions read from the disc drive modules into data to be sent to the computer, when the array disc memory equipment operates under control of a data read command sent from the computer; and data path setting means coupled between said data division and integration means and the disc drive modules, for setting a data path between said data division and integration means and the disc drive modules in accordance with data path instructions sent from the computer, so that (a) divided data portions expected to be input to disc drive modules having first identification information are input to installed disc drive modules having the same second identification information as the first identification information, respectively, when the array disc memory equipment operates in response to a write command; and (b) divided data portions expected to be output from disc drive modules having first identification information are output from installed disc drive modules having the same second identification information as the first identification information, respectively, when the array disc memory equipment operates in response to a read command.

An embodiment of the present invention can provide array disc equipment for preventing confusion from occurring in data storing and reading when disc drive modules (DRIVEs) are replaced, increased or decreased.

An embodiment of the present invention can provide for mitigation of the difficulties involved in determining which DRIVE has a wrong cable connection and can afford time savings in relation to the correction of the wrong cable connection, when DRIVEs are replaced, increased or decreased.

An embodiment of the present invention can provide for increased operation reliability of the array disc equipment and of a computer including the array disc equipment.

In accordance with an embodiment of the present invention, identification information is provided in respect of each DRIVE, a memory is provided for effecting a comparison operation in relation to the identification information every time power for DRIVEs is turned on.

When DRIVEs having good quality are initially installed correctly in the array disc equipment, identification information is read and stored in the memory as reference identification information. Thereafter when, for example, one of the DRIVEs is replaced by another good DRIVE, the power for the DRIVE is turned off and the replacement is performed. When the replacement is over, the power is turned on. In this case, there is possibility that a wrong cable connection has occurred. The same possibility arises when the number of DRIVEs is increased or decreased. When such replacement is performed, the operator is usually able to set a replacement message correctly in a logical table of the memory, without making any mistake because of a supervisory system provided in the array disc equipment or the computer. Thereafter, the identification information of the newly installed DRIVE is read and stored in the memory as the reference identification information instead of the replacement message. Therefore, confirmation of whether or not DRIVEs are correctly installed with correct cable connections can be performed by the above comparison operation.

Many cases of disconnecting and connecting the cables are to be considered, but the power of the DRIVEs is always turned off when the connection cables are disconnected and connected. Thus, so long as the comparison operation confirmation is performed every time the power of DRIVEs is turned on, this is sufficient to ensure correct connection.

In accordance with a first embodiment of the present invention, when a mismatch result is produced by the comparison operation, an alarm signal is produced for stopping the computer sending data write or read commands to the array disc equipment, so that data confusion can be prevented from occurring.

In accordance with a second embodiment of the present invention, when a mismatch result is produced, the problem of data confusion can be prevented from occurring without stopping the computer sending data write or read commands, by providing data path instructions so that the identification information from actually installed DRIVEs is stored to the correct logical position of the memory. This is equivalent to amending (correcting) the cable connection.

Embodiments of the present invention can provide for confirming or conforming logical address positions for disc drive modules installed in array disc memory equipment and more particularly can provide array disc memory equipment capable of confirming or conforming logical address positions for disc drive units therein when the disconnection and/or connection of cables attached to the disc drive modules is performed due to the replacement or the expansion of the disc drive modules.

Reference is made by way of example, to the accompanying drawings, in which:-
Fig. 1 is a schematic block diagram of previously proposed array disc equipment;
Fig. 2 is a schematic block diagram of array disc equipment in accordance with a first embodiment of the present invention;
Fig. 3 gives a representation of a logical table, for assistance in explaining a confirming function of array disc equipment embodying the present invention;
Fig. 4 is a flow chart for assistance in explaining steps for setting MF Nos. of DRIVEs having good quality, initially installed in array disc equipment embodying the present invention;
Fig. 5 is a flow chart for explaining steps for writing MF Nos. of newly replaced DRIVEs in the table and confirming whether cables are correctly connected in array disc equipment embodying the present invention;
Fig. 6 gives a representation of an example of a logical table, when DRIVEs are correctly installed in their logical positions respectively with correct cable connections in case of initial installation;
Fig. 7 gives a representation of another example of a logical table, when a DRIVE is replaced by another but installed correctly with correct cable connection;
Fig. 8 gives a representation of still another example of the logical table, when drives are installed incorrectly with wrong cable connection; and
Fig. 9 is a schematic block diagram of a data path setting circuit in array disc equipment according to a second embodiment of the present invention.

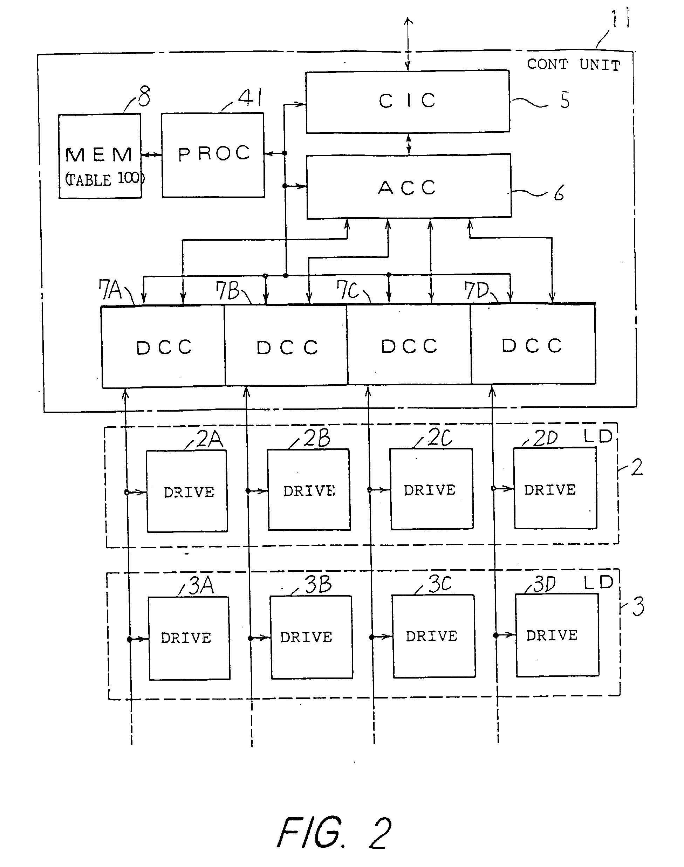

Array disc equipment in accordance with a first embodiment of the present invention is shown in Fig. 2. In Fig. 2 the same reference signs as are used in Fig. 1 designate the same or similar units or circuits as in Fig. 1. In Fig. 2, CONT UNIT 11 is functionally the same as CONT UNIT 1 in Fig. 1 except that CONT UNIT 11 has a non-volatile memory (MEM) 8, being a random access memory (RAM), for storing identification information relating to DRIVEs to be correctly installed in the array disc equipment, and PROC 41 is provided by modifying PROC 4 in Fig. 1 so as to operate with MEM 8.

As the identification information, manufacturing numbers (MF Nos.) of DRIVEs can be used. A MF No. is usually memorised in a designated area on a memory disc, located, for example, on the last track of the last cylinder of the memory disc and not normally accessible for users. In the following description of embodiments of the present invention, by way of example, MF Nos. will be referred to as the identification information, and MF Nos., stored in MEM 8, of DRIVEs correctly installed and normally operating in the array disc equipment will be called "reference MF Nos." hereinafter.

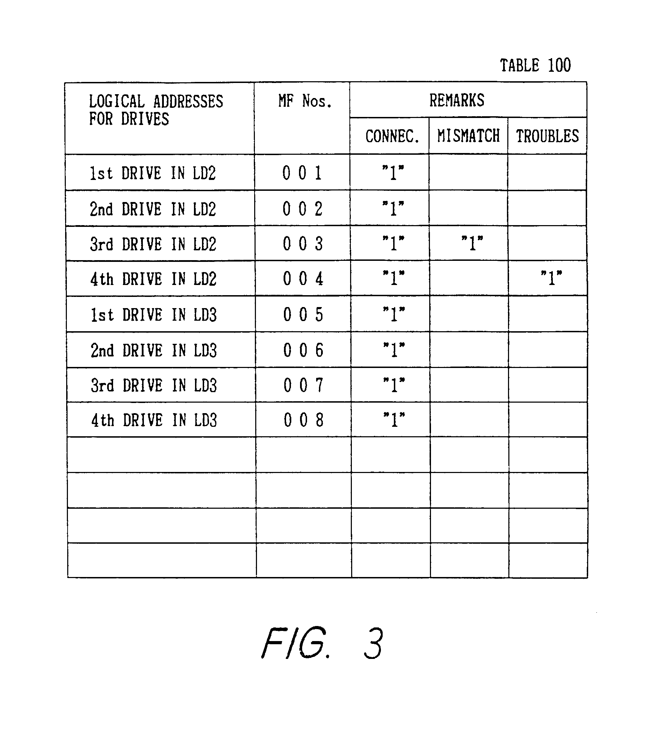

The reference MF Nos. are used by PROC 41 for judging whether DRIVEs installed or reconnected in the array disc equipment as a result of replacement or expansion are correctly connected by the connection cables in the array disc equipment, by comparing MF Nos. read from the installed DRIVEs with the reference MF Nos. In MEM 8, the state of the installed DRIVEs and the result of comparison are also stored, forming a kind of correspondence table. The correspondence table is represented as TABLE 100 in Fig. 2 and an example of TABLE 100 is shown in Fig. 3.

In TABLE 100 in Fig. 3, the reference MF Nos., remarks on the states of the cable connections, the results of comparison between MF Nos. read from the installed DRIVEs and the reference MF Nos., and on problems or troubles in the installed DRIVEs (if such occur), are tabulated in accordance with the logical addresses of DRIVEs to be installed in the array disc equipment. In TABLE 100, the numbers 001, 002, --- in the column for "MF Nos." are examples of reference MF Nos., a flag "1" in the column for CONNEC. represents a good connection, a flag "1" in the column for MISMATCH indicates that an MF No. read from an installed drive does not coincide with the reference MF No. of the drive to be installed and a flag "1" in the column for TROUBLES represents that the corresponding DRIVE has some problem. In the column for LOGICAL ADDRESSES in TABLE 100, blank rows are provided for future expansion of the number of DRIVEs. Increase or decrease in the number of DRIVEs is usually performed for each LD respectively.

Regarding TABLE 100, there is a rule that a reference MF No. is never changed unless an operator of the computer changes the reference MF No. with a message which indicates the replacement or the new installation of a DRIVE by operating a control keyboard, not depicted in Fig. 3, provided for the computer or the array disc equipment. The change of a reference MF No. by the operator will be detailed later.

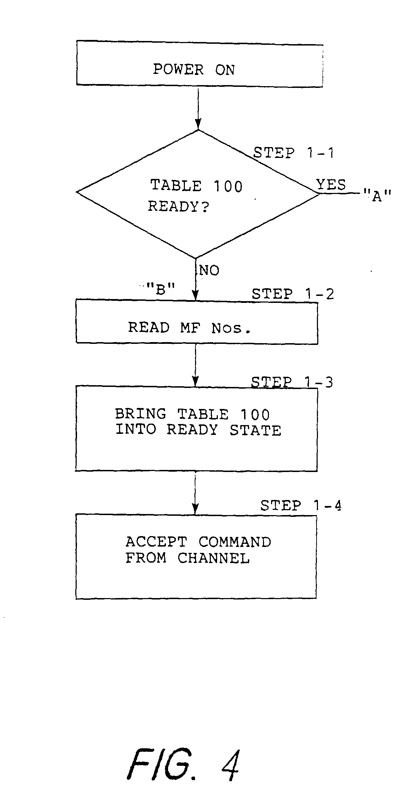

When array disc equipment of good quality is equipped in a computer initially in the factory, the reference MF Nos. must initially be stored in MEM 8. This is performed in accordance with the first flow chart shown in Fig. 4, as follows:
(1) after the array disc equipment is equipped in the computer, the power of the array disc equipment is turned on locally or in accordance with a command from the channel, which is represented as "POWER ON" in Fig. 4;
(2) when the power of the array disc equipment is turned on, the channel asks PROC 41 whether TABLE 100 has a flag indicating that the TABLE 100 is ready to be used by filling the TABLE 100 with the reference MF Nos., which is indicated by STEP 1-1, "TABLE 100 READY?";
(3) the TABLE 100 has not been accessed yet from the channel because the array disc equipment has, as yet, been only initially equipped or installed, so that PROC 41 answers back "NO" to the channel as shown at STEP 1-1 (what happens in the case of a "YES" answerback in STEP 1-1 is explained below). Then the channel sends a command to PROC 41 so as to place TABLE 100 in a state ready to be used, and thus PROC 41 instructs ACC 6 to read the MF Nos. of DRIVEs in the array disc equipment through DCCs 7A to 7D, as indicated by STEP 1-2, "READ MF Nos.";
(4) the MF Nos. read from DRIVEs are sent to PROC 41 so as to be stored in MEM 8 as the reference MF Nos., bringing TABLE 100 in the state ready to be used, which is indicated by STEP 1-3, "BRING TABLE 100 INTO READY STATE"; and
(5) when TABLE 100 achieves the ready state in STEP 1-3, the channel sends a command to PROC 41 to write or read data into or from the DRIVEs and then data writing or reading is performed as explained with reference to Fig. 1, which is indicated by STEP 1-4, "ACCEPT COMMAND FROM CHANNEL".

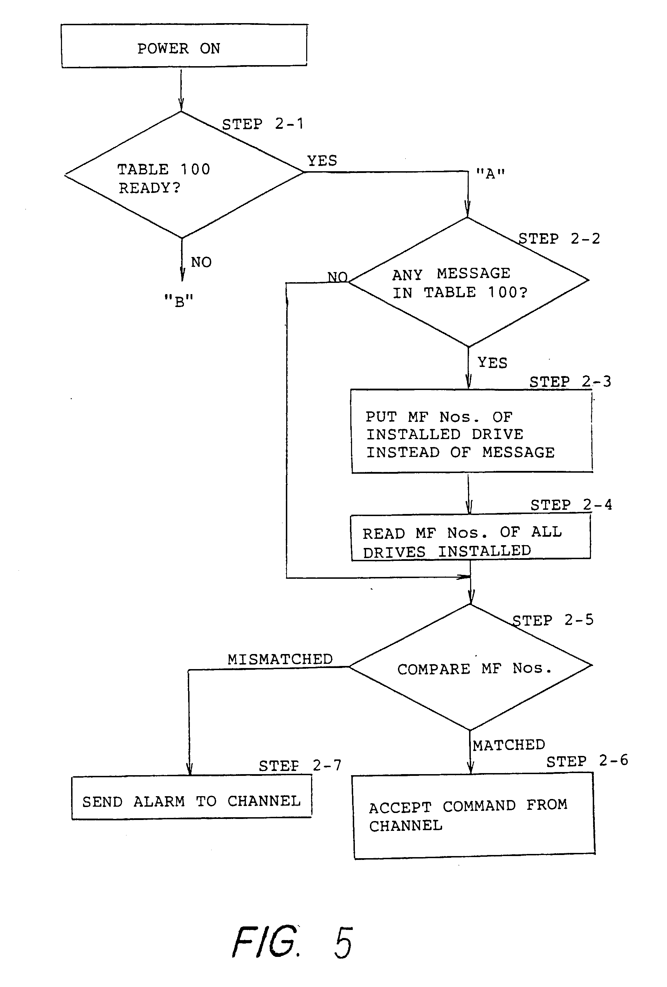

When writing or reading operations are performed in relation to array disc equipment, however, hardware troubles cannot be prevented from occurring in DRIVEs. When trouble occurs in the DRIVEs, the trouble is usually backed up by other auxiliary DRIVEs in LD. However, if the troubles increase beyond a predetermined threshold, PROC 41 senses this and produces an alarm signal, storing a trouble flag "1" in TABLE 100, as shown in Fig. 3. The alarm signal is also sent to the operator to inform the operator which DRIVE is faulty. When the operator finds the faulty DRIVE, he turns the local power to the faulty DRIVE off, or turns off the power of the array disc equipment, and replaces the faulty DRIVE with a new good DRIVE. Then, the operator amends TABLE 100, by operating a control keyboard, so as to put a replacement message in TABLE 100, instead of the reference MF No. of the faulty DRIVE. As a result of the amendment of TABLE 100 by the operator thus, the trouble flag in TABLE 100 disappears by operation of PROC 41. When a DRIVE is replaced thus, TABLE 100 is renewed by putting a new MF No., the MF No. of the replacement DRIVE, in the column having the replacement message and it is confirmed whether the replacement DRIVE is correctly installed. The steps of putting the new MF No. of the replacement DRIVE IN TABLE 100 and confirming whether the replacement DRIVE is installed are carried out in accordance with the second flow chart shown in Fig. 5, as follows:
(1) the local power of the replacement DRIVE, or the power of the array disc equipment, is turned on after the DRIVE replacement and amendment of TABLE 100 so as to put the replacement message in the relevant column instead of the reference MF No. of the faulty DRIVE, as represented by "POWER ON" in Fig. 5;
(2) then the channel commands PROC 41 to ask whether TABLE 100 is ready, as indicated by STEP 2-1, representing "TABLE 100 READY?";
(3) the TABLE 100 has been in the ready state in this case, so the PROC 41 answers back to the channel "YES" as shown in STEP 2-1 (following the branch represented by symbol "A" in this case. The result of a "NO" answerback in STEP 2-1 has been explained in Fig. 4: this branch is indicated by symbol "B"), then the channel asks PROC 41 whether TABLE 100 has any message on the column for the reference MF Nos., as indicated by STEP 2-2, "ANY MESSAGE IN TABLE 100?";
(4) since there is a replacement message in MEM 100, PROC 41 answers back to the channel "YES" as shown in STEP 2-2, and then the channel commands PROC 41 to put the MF No. of the replacement DRIVE in the column having the replacement message, and PROC 41 reads the MF No. of the replacement DRIVE and stores it in the column in place of the replacement message, as indicated by STEP 2-3, "PUT MF No. OF INSTALLED DRIVE INSTEAD OF MESSAGE";
(5) after so storing the MF No. of the replacement DRIVE, PROC 41 instructs DCCs to read MF Nos. of all DRIVEs installed in the array disc equipment, as indicated by STEP 2-4, "READ MF Nos. OF ALL DRIVES";
(6) then PROC 41 compares the read MF Nos. with MF Nos. which are now the reference MF Nos., stored in MEM 8 (TABLE 100), as indicated by STEP 2-5, "COMPARE MF Nos.";
(7) after performing the comparison in STEP 2-4, if the MF Nos. read from the installed DRIVE coincide with those stored in MEM 8 as shown by "YES" in STEP 2-5, PROC 41 accepts a command from the channel so as to perform data write or read, as indicated by STEP 2-6, "ACCEPT COMMAND FROM CHANNEL"; and
(8) if the MF Nos. read from the installed DRIVEs do not coincide with those stored in MEM 8, PROC 41 sends an alarm signal to the channel so that a command for performing data writing or reading is not sent to the array disc equipment any more, as indicated by STEP 2-7, representing "SEND ALARM TO CHANNEL".

As seen in the second flow chart, the operator performs two operations, in either of which it appears to be easy to make a mistake; one is DRIVE replacement, involving disconnecting and connecting cables, and the other is operating the control keyboard. However, mistakes are not made in the latter operation, because the array disc equipment or the computer provides a supervisory system by which a wrong operation in the control keyboard can never occur. However, the former operation is subject to the possibility of mistakes being made. In particular, wrong cable connections may be made during DRIVE replacement. However, this kind of mistake can be discovered in STEP 2-5. This is because, if a mistake is made in cable connection, MF Nos. read from replacement DRIVEs do not coincide with the reference MF Nos. stored in MEM 8.

In the case of increasing or decreasing the number of DRIVEs, it is not possible to make mistakes in cable connection. This is because an increase or decrease in the number of DRIVEs is performed in relation to every LD, not every DRIVE. However, since LDs are usually moved here and there in the setting field of the computer for increasing or decreasing DRIVEs, it is possible in this way to make mistakes in cable connection. Therefore, whether the DRIVEs are all correctly installed must be confirmed after the DRIVE increase or decrease is completed.

When DRIVEs are increased, the operator amends TABLE 100 by operating the control keyboard so as to put increase messages in blank locations in the MF Nos. column, providing information as to where the DRIVEs are to be installed as a result of the increase, after the increase of DRIVEs is over. When DRIVEs are decreased, the operator amends TABLE 100 by operating the control keyboard so as to put decrease messages in the MF Nos. column in correspondence to the removed DRIVEs, instead of MF Nos., after the DRIVEs to be decreased are removed from the array disc equipment.

After amending TABLE 100, the step of confirming whether the increase or decrease of DRIVEs is correctly performed (in other words, whether the cable connection for the increase or decrease of DRIVEs is correctly performed) is carried out in accordance with the same flow chart as in Fig. 5

In the above cases of replacing, increasing or decreasing DRIVEs, it is possible that an answer "NO" is output from, for example, STEP 2-2 if the operator forgets to amend TABLE 100. However, though the operator can make such a mistake in operating the control keyboard, in other words, though "NO" is output from STEP 2-2, this mistake can be detected in STEP 2-5 with the result that an alarm signal is output at STEP 2-7, producing no problem.

According to the first embodiment of the present invention, if a mistake is made in cable connection when DRIVEs are replaced, increased or decreased, PROC 41 only sends an alarm signal to the channel so as to stop the channel sending further commands for data writing or reading to PROC 41. Therefore, when wrong cable connection occurs, the operator must determine where the wrong cable connection exists and put the cable connection right. However, if a wrong cable connection can be made usable by the array disc equipment itself, instead of requiring action by the operator, the operator becomes free from the trouble of changing the cable connection and time spent for that can be saved. This improvement is provided in the second embodiment of the present invention.

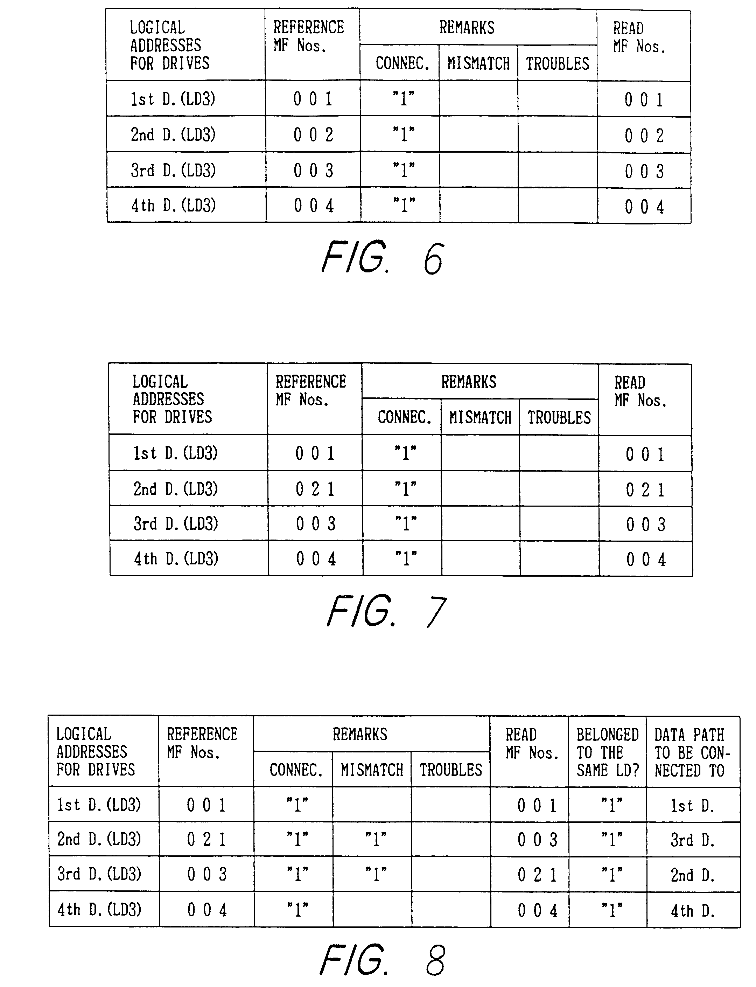

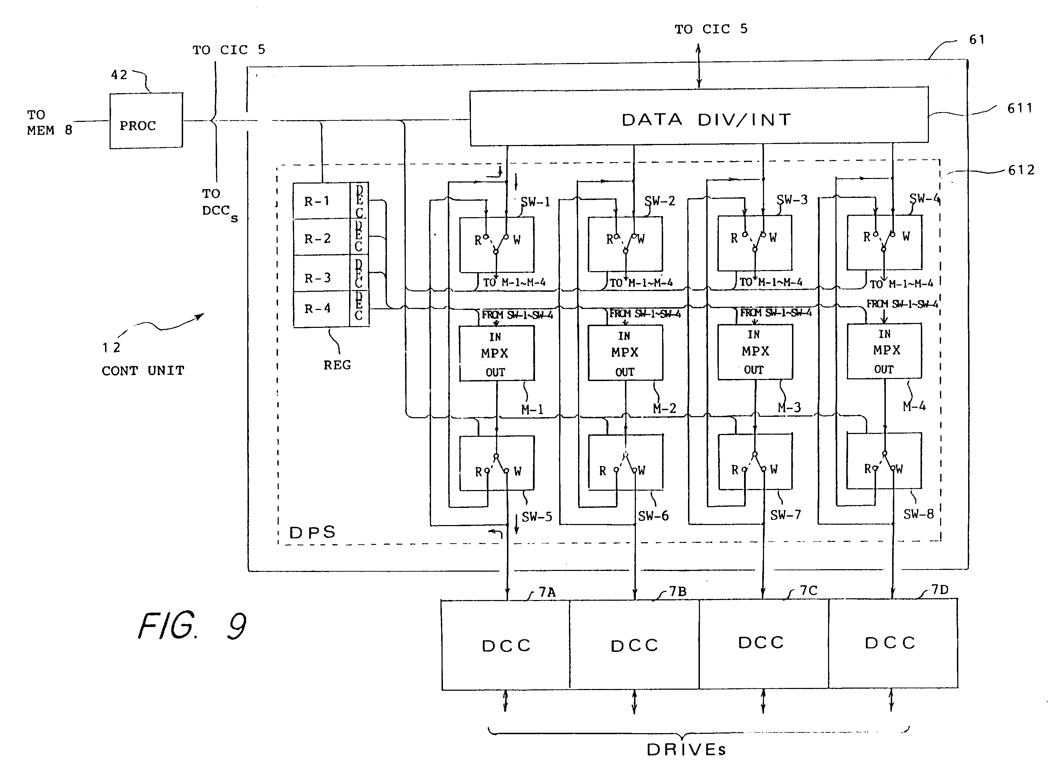

Before explaining the second embodiment in detail, TABLE 100 will be discussed further, with reference to Figs. 6 to 8 and, in particular, the case of the wrong cable connection will be explained in reference to Fig. 8. A concrete explanation of the second embodiment will be made by referring to the schematic block diagram shown in Fig. 9.

In Figs. 6 to 8, the same reference signs as are used in Fig. 3 designate the same logical addresses, MF Nos. or flags "1" as in Fig. 3, except that" DRIVE" is partially abbreviated to "D". In Fig. 9, the same reference signs as are used in Fig. 2 designate the same, or similar, units or circuits as in Fig. 2 except that CONT UNIT 12, PROC 42 and ACC 61 are functionally the same as CONT UNIT 11, PROC 41 and ACC 6 respectively but modified in accordance with the second embodiment. Furthermore, in Fig. 9, a data dividing and integrating circuit (DATA DIV/INT) 611 is as previously provided in ACC 6 in Fig. 1 or 2, but a data path setting circuit (DPS) 612 is a new circuit provided for the second embodiment.

Fig. 6 shows an example of TABLE 100 indicating no wrong cable connections and no troubles. However, another column "READ MF Nos." has been attached to TABLE 100 for the sake of explanation. The column "READ MF Nos." is for the read MF Nos. for DRIVEs installed in the array disc equipment.

Fig. 7 shows an example of a case when a DRIVE at the logical address of the second DRIVE in LD 3 (2nd D. (LD3)) is replaced by performing a correct cable connection.

When mistakes are made in the cable connections 2nd D. (LD3) and 3rd D. (LD3) so that those DRIVEs are connected so as to be opposite to each other, (e.g. cross-connected), two MISMATCH flags "1"s appear in respective columns as shown in Fig. 8. The mismatch will be clear from a comparison of the columns for REFERENCE MF Nos. and READ MF Nos. in Fig. 8. When such wrong cable connection occurs, an alarm signal is output to the channel from PROC 41 in the first embodiment. However, in the second embodiment, PROC 42 confirms that the installed DRIVEs all belong to the same LD 3 after the replacement is over, as shown by flags "1"s in the column labelled "BELONGED TO THE SAME LD?" in Fig. 8 and determines how the data paths should be changed for connecting the installed DRIVEs correctly, by comparing MF Nos. in columns REFERENCE MF Nos. and READ MF Nos. Then PROC 42 instructs ACC 61 so as to set the connections correctly by switching the routes between ACCs 7A to 7D and DATA DIV/INT 611 in DPS 612 in accordance with the determination of the data path.

In Fig. 8, additional columns such as READ MF Nos., BELONG TO THE SAME LD? and DATA PATH TO BE CONNECTED TO are provided in TABLE 100. However, they can alternatively be stored in PROC 42.

Fig. 9 is a schematic block diagram, focused on ACC 61, for assistance in explaining the second embodiment. In Fig. 9, the same reference signs as in Fig. 2 designate the same, or similar, units or circuits as in Fig. 2. Compared with ACC 6 previously used (e.g. in the first embodiment), in ACC 61, the data path setting circuit (DPS) 612 is added to the previous data dividing and integrating circuit (DATA DIV/INT) 611. The DPS 612 includes multiplexers (MPXs) M-1, M-2, M-3, and M-4, of the same number (four) as the DRIVEs in each LD, input switching circuits (input SWs) SW-1, SW-2, SW-3 and SW-4 placed at the inputs of the MPXs and output switching circuits (output SWs) SW-5, SW-6, SW-7 and SW-8 placed at the outputs of MPXs, respectively.

The MPXs M-1 to M-4 are for setting the paths of the divided data portions produced from DATA DIV/INT 611 to DCCs respectively when the divided data portions are written to the DRIVEs and for setting the paths of the divided data portions produced from the DCCs 7A to 7D to DATA DIV/INT 611 respectively when the divided data portions stored in DRIVEs are integrated at DATA DIV/INT 611. The paths are set in MPXs M-1 to M-4 by an instruction given from PROC 42. The instruction is produced in accordance with "DATA PATH TO BE CONNECTED TO" explained with reference to Fig. 8 and stored in a register (REG). The REG consists of divided registers R-1, R-2, R-3 and R-4 for storing instructions to M-1, M-2, M-3 and M-4 respectively and coders (COD) or decoders (DEC) attached to the divided registers respectively. When the MISMATCHED flags appear in TABLE 100 as shown in Fig. 8, PROC 42 sends the instructions to R-2 and R-3 corresponding to the DRIVEs having the wrong cable connection. The instructions sent to R-2 and R-3 are coded by coders COD (or decoders DEC) attached to R-2 and R-3 and sent to MPXs M-2 and M-3, for changing the data paths between DCC 7B and DATA DIV/INT 611 and between DCC 7C and DATA DIV/INT 611.

In Fig. 9, the data routes are set as follows: the input routes (INs) to MPXs M-1 to M-4 are switched by input SWs SW-1 to SW-4 so that the outputs from DATA DIV/INT 611 are fed to MPXs M-1 to M-4, and the output routes (OUTs) from MPXs M-1 to M-4 are switched by output SWs SW-5 to SW-8 so that inputs to DCCs 7A to 7D are output from the MPXs M-1 to M-4 respectively, by a write instruction (W) from PROC 42; and the input routes (INs) to MPXs M-1 to M-4 are switched by input SWs SW-1 to SW-4 so that the outputs from DCCs 7A to 7D are fed to MPXs M-1 to M-4, and the output routes (OUTs) from MPXs M-1 to M-4 are switched by output SWs SW-5 to SW-8 so that inputs to DATA DIV/INT 611 are output from the MPXs M-1 to M-4 respectively, by a read instruction (R) from PROC 42.

An embodiment of the present invention provides array disc memory equipment equipped with a computer and including disc drive modules for storing divided data portions. The equipment has means for confirming whether identification information read from disc drive modules installed in the equipment coincides with reference identification information read from disc drive modules previously installed in corresponding positions in the equipment, every time the disc drive modules are replaced, increased or decreased, and produces either an alarm signal for stopping the computer sending data write or read commands to the array disc memory equipment or a data path instruction for allowing the divided data to be correctly written or read from the disc drive modules when the read identification information does not coincide with the reference identification information.

## Claims

1. Array disc memory equipment (11,2,3), for use with a computer, for storing data sent from said computer by dividing the data into a plurality of divided data portions for storage in parallel, and for reading data and sending the read data to said computer by reading stored divided data portions and combining them into the read data, said array disc memory equipment (11,2,3) comprising a plurality of disc drive modules (2,3), for storing divided data portions, each said disc drive module comprising a memory disc on which identification information, identifying said disc drive module, is memorized;
characterised by:
read and memory means, for storing, in designated logical addresses of said read and memory means, first identification information relating to said disc drive modules (2,3) previously installed in designated positions of the array disc memory equipment, and operable to read second identification information on said disc drive modules (2,3) installed in the designated positions;
comparison means (8,41) operable to compare the second identification information with the first identification information indicated by the designated logical addresses every time a power supply of said disc drive modules is turned on;
confirmation means (8,41) for confirming, after performance of the comparison by said comparison means, whether the disc drive modules (2,3) installed in the designated positions, producing second identification information, belong to the same group and have second identification information identical to the first identification information;
data division and integration means (611) for
(i) dividing data, sent from said computer with which the array disc memory equipment is employed to said array disc memory equipment, into divided data portions to be stored in the disc drive modules, when said array disc memory equipment operates under control of a data write command sent from said computer, and
(ii) integrating divided data portions read from said disc drive modules (2,3) into data to be sent to said computer, when the array disc memory equipment operates under control of a data read command sent from said computer; and
data path setting means (612) coupled between said data division and integration means (611) and said disc drive modules (2,3), for setting a data path between said data division and integration means (611) and said disc drive modules (2,3) in accordance with data path instructions sent from said computer, so that
(a) divided data portions expected to be input to said disc drive modules (2,3) having first identification information are input to installed disc drive modules having the same second identification information as the first identification information, respectively, when the array disc memory equipment operates in response to a write command; and
(b) divided data portions expected to be output from those disc drive modules having first identification information are output from installed disc drive modules having the same second identification information as the first identification information, respectively, when the array disc memory equipment operates in response to a read command.

2. Array disc memory equipment according to claim 1, wherein the first identification information is identification information on said disc drive modules initially installed in the designated positions when the disc drive modules are initialized.

3. Array disc memory equipment according to claim 1 or 2, further comprising:
means for outputting alarm information to a computer with which the equipment is employed, for stopping the computer from sending
(i) a data write command to the array disc memory equipment, when the array disc memory equipment operates under control of such data write commands sent from the computer; and
(ii) a data read command to the array disc memory equipment, when the array disc memory equipment operates under control of such data read commands sent from the computer,
when said comparison means outputs a comparison result which indicates that the second identification information does not coincide with the first identification information; and
means for allowing the computer to send
(i) a data write command to the array disc memory equipment, when the array disc memory equipment operates under the control of such data write commands sent from the computer; and
(ii) a data read command to the array disc memory equipment, when the array disc memory equipment operates under the control of such data read commands sent from the computer,
when said comparison means output a comparison result which indicates that the second identification information coincides with the first identification information.

4. Array disc memory equipment according to claim 1, wherein said data path setting means comprises:
multiplexers equal in number to the disc drive modules, for providing data paths in accordance with the data path instruction; and
switching means for switching so that
(A) divided data portions output from said data division and integration means are sent to said multiplexers and divided data portions output from said multiplexers are sent to the disc modules, respectively, when the array disc memory equipment operates in response to a data write command, and
(B) divided data portions stored in the disc drive modules are sent to said multiplexers and the divided data output from said multiplexers are sent to said data division and integration means, respectively, when the array disc memory equipment operates in response to a data read command.

5. Array disc memory equipment according to any preceding claim, wherein the identification information uniquely identifies a respective disc drive module relative to any other disc drive module.

6. Array disc memory equipment according to claim 5, wherein the identification information is a manufacturing number of the disc drive module.

## Patentansprüche

1. Arrayplattenspeichervorrichtung (11, 2, 3) zur Verwendung mit einem Computer, zum Speichern von Daten, die von dem Computer gesendet werden, indem die Daten in eine Vielzahl von Teildatenabschnitten zum parallelen Speichern geteilt werden, und zum Lesen von Daten und Senden der gelesenen Daten zu dem Computer, indem gespeicherte Teildatenabschnitte gelesen und sie zu den gelesenen Daten kombiniert werden, welche Arrayplattenspeichervorrichtung (11, 2, 3) eine Vielzahl von Plattenlaufwerksmodulen (2, 3) umfaßt, zum Speichern von Teildatenabschnitten, wobei jedes Plattenlaufwerksmodul eine Speicherplatte umfaßt, auf der Identifikationsinformationen, die das Plattenlaufwerksmodul identifizieren, gespeichert sind; gekennzeichnet durch:
ein Lese- und Speichermittel zum Speichern, an bezeichneten logischen Adressen des Lese- und Speichermittels, erster Identifikationsinformationen bezüglich der Plattenlaufwerksmodule (2, 3), die zuvor an bezeichneten Positionen der Arrayplattenspeichervorrichtung installiert wurden, und das betriebsfähig ist, um zweite Identifikationsinformationen auf den Plattenlaufwerksmodulen (2, 3) zu lesen, die an den bezeichneten Positionen installiert sind;
ein Vergleichsmittel (8, 41), das betriebsfähig ist, um die zweiten Identifikationsinformationen mit den ersten Identifikationsinformationen, die durch die bezeichneten logischen Adressen angegeben werden, jedes Mal zu vergleichen, wenn eine Energiezufuhr der Plattenlaufwerksmodule eingeschaltet wird;
ein Bestätigungsmittel (8, 41) zum Bestätigen, nach der Ausführung des Vergleichs durch das Vergleichsmittel, ob die Plattenlaufwerksmodule (2, 3), die an den bezeichneten Positionen installiert sind, wobei sie zweite Identifikationsinformationen erzeugen, zu derselben Gruppe gehören und zweite Identifikationsinformationen haben, die mit den ersten Identifikationsinformationen identisch sind;
ein Datenteil- und -integrationsmittel (611)
(i) zum Teilen von Daten, die von dem Computer, mit dem die Arrayplattenspeichervorrichtung eingesetzt wird, zu der Arrayplattenspeichervorrichtung gesendet werden, in Teildatenabschnitte, die in den Plattenlaufwerksmodulen zu speichern sind, wenn die Arrayplattenspeichervorrichtung unter der Steuerung eines Datenschreibbefehls arbeitet, der von dem Computer gesendet wird, und
(ii) zum Integrieren von Teildatenabschnitten, die aus den Plattenlaufwerksmodulen (2, 3) gelesen werden, zu Daten, die zu dem Computer zu senden sind, wenn die Arrayplattenspeichervorrichtung unter der Steuerung eines Datenlesebefehls arbeitet, der von dem Computer gesendet wird; und
ein Datenwegeinstellmittel (612), das zwischen dem Datenteil- und -integrationsmittel (611) und den Plattenlaufwerksmodulen (2, 3) gekoppelt ist, zum Einstellen eines Datenweges zwischen dem Datenteil- und -integrationsmittel (611) und den Plattenlaufwerksmodulen (2, 3) gemäß Datenweginstruktionen, die von dem Computer gesendet werden, so daß
(a) Teildatenabschnitte, die den Plattenlaufwerksmodulen (2, 3) einzugeben sind, die erste Identifikationsinformationen haben, installierten Plattenlaufwerksmodulen eingegeben werden, die jeweilig dieselben zweiten Identifikationsinformationen wie die ersten Identifikationsinformationen haben, wenn die Arrayplattenspeichervorrichtung als Reaktion auf einen Schreibbefehl arbeitet; und
(b) Teildatenabschnitte, die von jenen Plattenlaufwerksmodulen auszugeben sind, die erste Identifikationsinformationen haben, von installierten Plattenlaufwerksmodulen ausgegeben werden, die jeweilig dieselben zweiten Identifikationsinformationen wie die ersten Identifikationsinformationen haben, wenn die Arrayplattenspeichervorrichtung als Reaktion auf einen Lesebefehl arbeitet.

2. Arrayplattenspeichervorrichtung nach Anspruch 1, bei der die ersten Identifikationsinformationen Identifikationsinformationen auf den Plattenlaufwerksmodulen sind, die zuerst an den bezeichneten Positionen installiert waren, als die Plattenlaufwerksmodule initialisiert wurden.

3. Arrayplattenspeichervorrichtung nach Anspruch 1 oder 2, ferner mit:
einem Mittel zum Ausgeben von Alarminformationen an einen Computer, mit dem die Vorrichtung eingesetzt wird, zum Stoppen des Computers beim Senden
(i) eines Datenschreibbefehls an die Arrayplattenspeichervorrichtung, wenn die Arrayplattenspeichervorrichtung unter der Steuerung von solchen Datenschreibbefehlen arbeitet, die von dem Computer gesendet werden; und
(ii) eines Datenlesebefehls an die Arrayplattenspeichervorrichtung, wenn die Arrayplattenspeichervorrichtung unter der Steuerung von solchen Datenlesebefehlen arbeitet, die von dem Computer gesendet werden,
wenn das Vergleichsmittel ein Vergleichsresultat ausgibt, das angibt, daß die zweiten Identifikationsinformationen nicht mit den ersten Identifikationsinformationen koinzidieren; und
einem Mittel zum Zulassen, daß der Computer
(i) einen Datenschreibbefehl an die Arrayplattenspeichervorrichtung sendet, wenn die Arrayplattenspeichervorrichtung unter der Steuerung von solchen Datenschreibbefehlen arbeitet, die von dem Computer gesendet werden; und
(ii) einen Datenlesebefehl an die Arrayplattenspeichervorrichtung sendet, wenn die Arrayplattenspeichervorrichtung unter der Steuerung von solchen Datenlesebefehlen arbeitet, die von dem Computer gesendet werden,
wenn das Vergleichsmittel ein Vergleichsresultat ausgibt, das angibt, daß die zweiten Identifikationsinformationen mit den ersten Identifikationsinformationen koinzidieren.

4. Arrayplattenspeichervorrichtung nach Anspruch 1, bei der das Datenwegeinstellmittel umfaßt:
Multiplexer, die in der Anzahl den Plattenlaufwerksmodulen gleich sind, zum Vorsehen von Datenwegen gemäß der Datenweginstruktion; und
ein Schaltmittel zum Schalten, so daß
(A) Teildatenabschnitte, die von dem Datenteilund -integrationsmittel ausgegeben werden, an die Multiplexer gesendet werden und Teildatenabschnitte, die von den Multiplexern ausgegeben werden, jeweilig an die Platten-module gesendet werden, wenn die Arrayplattenspeichervorrichtung als Reaktion auf einen Datenschreibbefehl arbeitet, und
(B) Teildatenabschnitte, die in den Plattenlaufwerksmodulen gespeichert sind, an die Multiplexer gesendet werden und die Teildaten, die von den Multiplexern ausgegeben werden, jeweilig an das Datenteil- und -integrationsmittel gesendet werden, wenn die Arrayplattenspeichervorrichtung als Reaktion auf einen Datenlesebefehl arbeitet.

5. Arrayplattenspeichervorrichtung nach irgendeinem vorhergehenden Anspruch, bei der die Identifikationsinformationen ein jeweiliges Plattenlaufwerksmodul bezüglich irgendeines anderen Plattenlaufwerksmoduls eindeutig identifizieren.

6. Arrayplattenspeichervorrichtung nach Anspruch 5, bei der die Identifikationsinformationen eine Herstellungsnummer des Plattenlaufwerksmoduls sind.

## Revendications

1. Equipement de mémorisation sous forme de réseau de disques (11, 2, 3) destiné à être utilisé avec un ordinateur, pour mémoriser les données envoyées par ledit ordinateur en divisant les données en une pluralité de parties de données divisées pour mémorisation en parallèle et pour lire les données et envoyer les données lues audit ordinateur en lisant les parties de données divisées mémorisées et en les combinant en données lues, ledit équipement de mémorisation sous forme de réseau de disques (11, 2, 3) comprenant une pluralité de modules de lecture de disque (2, 3), pour mémoriser les parties de données divisées, chacun desdits modules de lecture de disque comprenant un disque de mémoire sur lequel des données d'identification, identifiant ledit module de lecture de disque, sont mémorisées ; caractérisé par :
des moyens de lecture et de mémorisation, destinés à mémoriser, dans des adresses logiques désignées desdits moyens de lecture et de mémorisation, des premières informations d'identification concernant lesdits modules de lecture de disque (2,) installés au préalable à des positions désignées de l'équipement de mémorisation sous forme de réseau de disques, et susceptibles de fonctionner pour lire des secondes informations l'identification sur lesdits modules de lecture de disque (2, 3) installés aux positions désignées ;
des moyens de comparaison (8, 41) susceptibles de fonctionner pour comparer les secondes informations d'identification aux premières informations d'identification indiquées par les adresses logiques désignées à chaque fois qu'une alimentation desdits modules de lecture de disque est mise en marche ;
des moyens de confirmation (8, 41) destinés à confirmer, après l'exécution de la comparaison par lesdits moyens de comparaison, si les modules de lecture de disque (2, 3) installés aux positions désignées, produisant les secondes informations d'identification, appartiennent au même groupe et comportent des secondes informations d'identification identiques aux premières informations d'identification ;
des moyens de division et d'intégration de données (611) destinés à :
(i) diviser les données, envoyées par ledit ordinateur avec lequel l'équipement de mémorisation sous forme de réseau de disques est employé audit équipement de mémorisation sous forme de réseau de disques, en parties de données divisées à mémoriser dans les modules de lecture de disque, lorsque ledit équipement de mémorisation sous forme de réseau de disques fonctionne sous le contrôle d'une commande d'écriture de données envoyée par ledit ordinateur, et
(ii) intégrer les parties de données divisées lues à partir desdits modules de lecture de disque (2, 3) aux données à envoyer audit ordinateur, lorsque l'équipement de mémorisation sous forme de réseau de disques fonctionne sous le contrôle d'une commande de lecture de données envoyée par ledit ordinateur ; et
des moyens de fixation de chemin de données (612) couplés entre lesdits moyens de division et d'intégration de données (611) et lesdits modules de lecture de disque (2, 3), destinés à fixer un chemin de données entre lesdits moyens de division et d'intégration de données (611) et lesdits modules de lecture de disque (2, 3) conformément aux instructions de chemin de données envoyées par ledit ordinateur, de sorte que :
(a) les parties de données divisées supposées entrer dans lesdits modules de lecture de disque (2, 3) comportant les premières informations d'identification sont entrées dans les modules de lecture de disque installés comportant des secondes informations d'identification identiques aux premières informations d'identification, respectivement, lorsque l'équipement de mémorisation sous forme de réseau de disques fonctionne en réponse à une commande d'écriture ; et
(b) les parties de données divisées supposées sortir des modules de lecture de disque comportant les premières informations d'identification sont sorties des modules de lecture de disque installés comportant des secondes informations d'identification identiques aux premières informations d'identification, respectivement, lorsque l'équipement de mémorisation sous forme de réseau de disques fonctionne en réponse à une commande de lecture.

2. Equipement de mémorisation sous forme de réseau de disques selon la revendication 1, dans lequel les premières informations d'identification sont les informations d'identification sur lesdits modules de lecture de disque installés initialement aux positions désignées lorsque les modules de lecture de disque sont initialisés.

3. Equipement de mémorisation sous forme de réseau de disques selon la revendicaiton 1 ou 2 comprenant, de plus :
des moyens destinés à sortir des informations d'alarme vers un ordinateur avec lequel l'équipement est employé afin d'arréter l'envoi par l'ordinateur :
(i) d'une commande d'écriture de données à l'équipement de mémorisation sous forme de réseau de disques, lorsque l'équipement de mémorisation sous forme de réseau de disques fonctionne sous le contrôle de ces commandes d'écritures de données envoyées par l'ordinateur ; et
(ii) d'une commande de lecture de données à l'équipement de mémorisation sous forme de réseau de disques, lorsque l'équipement de mémorisation sous forme de réseau de disques fonctionne sous le contrôle de ces commandes de lecture de données envoyées par l'ordinateur,
lorsque lesdits moyens de comparaison sortent un résultat de comparaison qui indique que les secondes informations d'identification ne coïncident pas avec les premières informations d'identification ; et
des moyens destinés à autoriser l'ordinateur à envoyer :
(i) une commande d'écriture de données à l'équipement de mémorisation sous forme de réseau de disques, lorsque l'équipement de mémorisation sous forme de réseau de disques fonctionne sous le contrôle de ces commandes d'écriture de données envoyées par l'ordinateur ; et
(ii) une commade de lecture de données à l'équipement de mémorisation sous forme de réseau de disques, lorsque l'équipement de mémorisaiion sous forme de réseau de disque fonctionne sous le contrôle de ces commandes de lecture de données envoyées par l'ordinateur,
lorsque lesdits moyens de comparaison sortent un résultat de comparaison qui indique que les secondes informations d'identification coïncident avec les premières informations d'identification.

4. Equipement de mémorisation sous forme de réseau de disques selon la revendication 1, dans lequel lesdits moyens de fixation de chemin de données comprennent :
des multiplexeurs égaux en nombre aux modules de lecture de disque, destinés à établir des chemins de données conformément à l'instruction de chemin de données ; et
des moyens de commutation destinés à commuter, ne sorte que :
(A) les parties de données divisées sorties desdits moyens de division et d'intégration de données soient envoyées auxdits multiplexeurs et que les parties de données divisées sorties desdits multiplexeurs soient envoyées aux modules de disques, respectivement, lorsque l'équipement de mémorisation sous forme de réseau de disques fonctionne en réponse à une commande d'écriture de données, et
(B) les parties de données divisées mémorisées dans les modules de lecture de disque soient envoyées auxdits multiplexeurs et que les données divisées sorties desdits multiplexeurs soient envoyées auxdits moyens de division et d'intégration de données, respectivement, lorsque l'équipement de mémorisation sous forme de réseau de disques fonctionne en réponse à une commande de lecture de données.

5. Equipement de mémorisation sous forme de réseau de disques selon l'une quelconque des revendications précédentes, dans lequel les informations d'identification identifient uniquement un module de lecture de disque respectif par rapport à n'importe quel autre module de lecture de disque.

6. Equipement de mémorisation sous forme de réseau de disques selon la revendication 5, dans lequel les informations d'identification sont un numéro de fabrication du module de lecture de disque.
